# EUROPEAN PATENT SPECIFICATION

(11) **EP 0 562 414 B1**
(45) Date of publication and mention of the grant of the patent: **04.03.1998**
(21) Application number: 93104211.3
(22) Date of filing: 16.03.1993
(51) Int. Cl.: H03F 1/30

(54) **Sound intermediate frequency amplifier for a broadcast receiver**
Ton-Zwischenfrequenz-Verstärker für einen Empfänger
Amplificateur de fréquence intermédiaire de son pour un récepteur

(30) Priority: 25.03.1992 EP 92400816
(43) Date of publication of application: 29.09.1993
(73) Proprietor: THOMSON multimedia, 92400 Courbevoie (FR)
(72) Inventor: Chiok, Huan Seng, Singapore 2264 (SG)
(74) Representative: Brykman, Georges

(56) References cited:
- EP-A- 0 069 843
- DE-A- 2 854 196
- DE-C- 3 244 254
- GB-A- 2 096 423

## Description

The invention relates to a sound intermediate frequency amplifier according to the introductary part of claim 1.
Within a television receiver during a switching from "OFF" to "ON" or switching from "Stand-by" to "ON" audible disturbance within the reproduced sound occurs, which is generally called "POP". The inventor realized that these disturbances in form of a click is due to sudden change in the operating voltage fed to the sound intermediate frequency amplifier IC. According to prior art capacitors are introduced to prevent such a sudden change in operating voltage. However such known circuits operates not sufficiently so that in most cases an indesirable "POP" remains.
An example of such a circuit is given by the patent DE 3244254 in the name of the applicant. This document will be referred to as D1 heredown.

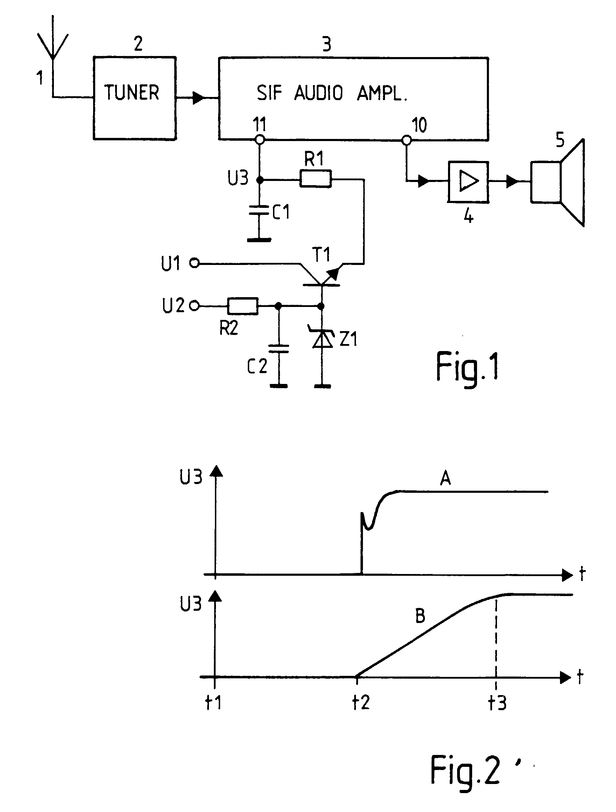

Figure 2 of this document shows a circuit of a sound amplifier.
The input of this circuit is between terminals 1 and 2 of figure 2. The input is made as explained above through a coupling capacitor C1.

A power supply of the amplifier is made through terminals 3 and 4. In the circuit of figure 2 an anti-pop circuit is implemented. This circuit is made by transistor T7 where the collector emitter-path delivers a supply current to the emitters of transistor T1 and T2. Transistors T1 and T2 are the differential input stage of the amplifier, which has one input coupled to terminal 1 and the other input coupled to the amplifier output by means of the feedback loop R5, R6, C3. In this circuit, in order to avoid that a sudden change of the power supply would generate the pop sound, the supply current to T1 and T2 is applied in a slowly increasing way. This result is achieved by the fact that the base of transistor T7 is supplied through an R12 C2 integrating circuit connected to direct voltage Vcc (terminal 3) via a resistor R4.

Such a circuit would-prevent pop sound to occur as a result of a sudden change of the supplied voltage. However as explained above such a circuit would not prevent pop sound to occur by the fact that a current is flowing accross C1. If C1 is fully charged, there is no risk of creating a pop sound but before this quiescent state is achieved pop sound is likely to arise.

It is an object of the invention as defined in Claim 1 to modify the circuit for the sound intermediate frequency amplifier in such a way that such disturbances in audio reproduction like "POP" do not occur or remain inaudible.

The invention relates to a circuit of a receiver having a sound intermediate frequency amplifier in the form of an IC having an operating voltage terminal connected to a source of a dc operating potential. The invention consists in that said dc source is connected to said terminal via the collector/emitter-path of a transistor and that a second source of operating potential is connected via a RC integrating network to the base of said transistor, the base being connected to ground via a zener diode. In a prefered embodiment of the invention a resistor is provided between said transistor and said operating voltage terminal of said IC, whereas the operating voltages are derived by rectification of the ouptput pulse voltage of the line fly-back transformer of a television receiver.

The circuit of the invention fulfils two objects simultaneously. On one hand the circuit prevents a sudden change in operating voltage fed to IC and provides a soft or smooth increase in operating voltage during switch on of the receiver. On the other hand the circuit effects an additional stabilization of the operating voltage fed to the sound intermediate frequency amplifier IC by the action of said diode. So very good results are achieved by a rather simple circuit which generally includes only one transistor, one resistor, one capacitor and one zener diode.

In order that the invention may be better understood and easily carried out into practice an embodiment of the invention is described in connection with an accompanying drawing. In the drawing
- Fig. 1: shows a sound intermediate frequency amplifier together with the circuit according to the inven tion
- Fig. 2: waweforms for illustrating the function of the circuit according to Fig. 1.

In Fig. 1 an antenna 1 is connected to a tuner 2 of a television receiver. Output of tuner 2 is connected to a sound intermediate frequency amplifier and audio amplifier IC 3. IC 3 among other terminals has an operating voltage terminal 11 for supplying a dc operating voltage thereto and a terminal 10 providing output audio frequency signal which is fed via an audio amplifier 4 to loudspeaker 5 for sound reproduction.

Operating voltage U1 for IC 3 is supplied via the collector/emitter-path of a transistor T1 and resistor R1 to terminal 11 which is further connected to ground via capacitor C1. A second dc operating voltage U2 is connected via integrating circuit with resistor R2 and capacitor C2 to base of transistor T1, the base being connected to ground via zener diode Z1.

In connection with Fig. 2 the operating of the circuit according to Fig. 1 is explained. From t1 to t2 television receiver is switched off so that voltage U3 at terminal 11 is zero and no output voltage is fed from terminal 10 to amplifier 4. At t2 the television receiver is switched on from "OFF" status or "stand-by" status. Waveform A shows a sudden rise or jump within voltage U3 at terminal 11, said jump generating the indesi-red POP at loudspeaker 5. In the circuit according to Fig. 1 at t2 capacitor C2 is unloaded so that voltage at base of T1 is zero so that short after t2 T1 is cut off and U3 cannot make the sudden change or jump as in the waveform A. After t2 capacitor C2 is charged via R2 so that the voltage at base of T1 increases in positive direction. T1 becomes conductive so that also U3 increases smoothly according to waveform B. At t3 voltage U3 reaches the final value which is the same at the final value of waveform A. It can be seen that the sudden change or jump of waveform A which is a reason for undesired POP is avoided and undesired POP occurs not at loudspeaker 5.

At t3 voltage at base of T1 reaches the zener voltage of Z1 and cannot further increase. As the voltage at the emitter of T1 always remains closely to the voltage at base of T1 by a difference of the emitter to base voltage of about 0,7 V, voltage at the emitter of T1 and so voltage U3 is stabilized by the action of zener diode Z1. Any variation in U1 therefore are compensated so that the IC 3 is always supplied at terminal 11 with a constant stabilized dc operating potential U3.

In a television receiver dc voltages U1 and U2 may be generated by rectification of the pulse voltage at the line output transformer of the television receiver. Hence, the circuit according to Fig. 1 solves the "POP" sound problem and also helps to stabilize the dc supply voltage for SIF-IC 3.

Within a practical tested circuit according to Fig.1 the elements shown in Fig. 1 had the following values:
R1: 1,2 Ohm
R2: 2,2 kOhm
C1: 47 mikroF
C2: 470 mikroF
T1: type BC637
Z1: type ZPD13
U1: + 13 V
U2: + 25V

## Claims

1. Circuit of a broadcast receiver for avoiding pop sound from a loudspeaker (5), the receiver comprising a sound intermediate frequency amplifier (3) which feeds an amplifier (4) feeding said loudspeaker (5), said circuit producing a ramp shaped operating voltage from a first direct current source (U1) via a collector-emitter path of a transistor having three electrodes, the collector, the emitter and a base characterized in that the sound intermediate frequency amplifier is in the form of an integrated circuit (3) having an output (10) feeding the amplifier (4) of the loudspeaker, an operating voltage terminal (11) connected to the collector emitter path of said transistor (T1), a second source of operating voltage (U2) being connected to the base of said transistor T1, via an RC integrating network (R2C2) said base being directly connected to ground via a zener diode Z1.

2. Circuit according to claim 1 in which said collector emitter path of transistor (T1) is connected to the operating voltage terminal (11) of IC (3) via a RC circuit (R1C1).

3. Amplifier according to claim 1, characterized in that said dc from operating voltage (U1, U2) are derived from a line flyback transformer of a television receiver via rectifier circuits.

4. Television receiver with an amplifier according to one of the claims 1-3.

## Patentansprüche

1. Schaltkreis eines Rundfunk Empfängers zur Vermeidung von Knackgeräusch bei einem Lautsprecher (5), wobei der Empfänger einen Ton-Zwischenfrequenz-Verstärker (3) enthält, der einen den Lautsprecher (5) speisenden Verstärker (4) speist, wobei der Schaltkreis aus einer ersten Gleichstromquelle (U1) über einen Kollektor-Emitter pfad eines Transistors, der drei Elektroden nämlich den Kollektor, den Emitter und eine Basis hat, eine rampenförmige Betriebspannung erzeugt, dadurch gekennzeichnet, daß der Ton-Zwischenfrequenz-Verstärker in Form eines integrierten Schaltkreises (3) vorliegt, der einen den Lautsprecher-Verstärker (4) speisenden Ausgang (10) besitzt, wobei eine Betriebspannungsendung (11) an dem Kollektor Emitter Pfad des Transistors (T1) angeschlossen ist, eine zweite Betriebspannungsquelle (U2) über ein RC- integrierendes Netzwerk (R2, C2) an der Basis des Transistors T1 angeschlossen ist, wobei die Basis über eine Zenerdiode (Z1) direkt mit Erde verbunden ist.

2. Schaltkreis nach Anspruch 1 in dem der Kollektor Emitter Pfad des Transistors (T1) über einen RC Schaltkreis (R1, C1) an der Betriebspannungsendung (11) des integrierten Schaltkreises (3) angeschlossen ist.

3. Verstärker nach Anspruch 1, dadurch gekennzeichnet, daß der aus der Betriebspannung (U1, U2) erhaltene Gleichstrom über Gleichrichterschaltkreise aus einem Linien Rücklauftransformator eines Fernsehempfängers erzeugt wird.

4. Fernsehempfänger, der einen verstärker nach einem beliebigen der Ansprüche 1-3 enthält.

## Revendications

1. Circuit d'un récepteur pour éviter un bruit sec en provenance d'un haut-parleur (5), le récepteur comprenant un amplificateur de fréquence intermédiaire de son (3) qui alimente le dit haut parleur (5), ledit circuit produisant une tension de fonctionnement en forme de rampe provenant à partir d'une première source de courant continu (U1) et par l'intermédiaire du chemin collecteur-émetteur d'un transistor ayant trois électrodes, le collecteur, l'émetteur et une base, caractérisé en ce que l'amplificateur de fréquence intermédiaire de son est sous la forme d'un circuit intégré (3) ayant une sortie (10) alimentant l'amplificateur (4) du haut-parleur, une borne (11) de tension de fonctionnement connectée au chemin collecteur-émetteur dudit transistor (T1), une seconde source de courant continu (U2) étant connectée à la base dudit transistor (1) à travers un réseau RC intégrateur (R2, C2), ladite base étant directement connectée à la masse à travers une diode zener Z1.

2. Circuit selon la revendication 1 dans lequel ledit chemin collecteur-émetteur du transistor (T1) est connecté à la borne (11) de tension de fonctionnement (T1) du circuit intégré (3) à travers un circuit RC (R1,C1).

3. Amplificateur selon la revendication 1, caractérisé en ce que les dites tensions continues provenant d'une tension de fonctionnement (U1, U2) sont issues d'un transformateur de retour de ligne d'un récepteur de télévision à travers des circuits redresseurs.

4. Récepteur de télévision avec un amplificateur selon l'une des revendications 1 à 3.
